# EUROPEAN PATENT APPLICATION

(11) **EP 4 776 517 A1**
(43) Date of publication of application: **15.07.2026**
(21) Application number: 24862019.7
(22) Date of filing: 05.09.2024
(51) Int. Cl.: H04B 1/04, H03F 1/56

(54) **RADIO FREQUENCY FRONT-END MODULE WITH IMPEDANCE MISMATCH PROTECTION, ELECTRONIC DEVICE, AND METHOD**

(30) Priority: 06.09.2023 CN 202311142721
(71) Applicant: Vanchip (Tianjin) Technology Co. Ltd, Tianjin 300457 (CN)
(72) Inventor: ZHAO, Jinxin, Tianjin 300457 (CN); BAI, Yunfang, Tianjin 300457 (CN)
(74) Representative: Wang, Bo
(86) International application number: PCT/CN2024/117036
(87) International publication number: WO 2025/051179

(57) **Abstract**

Disclosed in the present invention are a radio frequency front-end module with impedance mismatch protection, an electronic device, and a method. The radio frequency front-end module comprises at least one transmit channel, and the transmit channel comprises an input power measurement circuit, a power amplifier circuit, a matching circuit, a load measurement circuit, and a gain control circuit, wherein the input power measurement circuit measures the power of an input radio frequency signal of the transmit channel; the load measurement circuit measures output forward transmission power and reverse transmission power in an output radio frequency signal and calculates a difference; and the gain control circuit compares an input power value and the difference between the output forward transmission power and reverse transmission power with a set first threshold value and a set second threshold value respectively, and outputs a control signal generated on the basis of the comparison result to the power amplifier circuit, so as to adjust the working state of the power amplifier circuit. Thus, impedance mismatch protection is achieved.

## Description

### BACKGROUND

### Technical Field

The present invention relates to a radio frequency front-end module with impedance mismatch protection, also relates to an electronic device including the radio frequency front-end module, and further relates to a control method for implementing impedance mismatch protection by a radio frequency front-end module, which belong to the field of radio frequency integrated circuit technologies.

### Related Art

In a mobile communication device, based on a theoretical design of a radio frequency antenna, an input impedance and output impedance of a radio frequency front-end module are both 50 Ω. However, in actual application, an impedance of antenna load can significantly change with changes in surrounding environmental factors to deviate from 50 Ω. For example, an abnormal load, a temperature change, and changes in factors such as a holding manner all cause load impedance mismatch, a reflection phenomenon of a radio frequency signal, and an increase in a voltage standing wave ratio (VSWR). Various indexes of a power amplifier, such as a gain, power consumption, and linearity, are usually designed in a case that it is theoretically assumed that the impedance is 50 Ω, so that a deviation exists between actual working performance of the power amplifier and theoretical performance of the power amplifier. In a case that input power of the power amplifier is relatively high, when severe load impedance mismatch occurs, the voltage or current of the power amplifier can increase and approaches a limit value. Consequently, components of the power amplifier may be burned out. Therefore, load impedance mismatch causes a fatal threat to operation reliability of the power amplifier.

### SUMMARY

A first technical problem to be solved by the present invention is to provide a radio frequency front-end module with impedance mismatch protection.

Another technical problem to be solved by the present invention is to provide an electronic device including the radio frequency front-end module.

Still another technical problem to be solved by the present invention is to provide a control method for implementing impedance mismatch protection by a radio frequency front-end module.

To achieve the foregoing objective, the present invention uses the following technical solutions:
According to a first aspect of the embodiments of the present invention, a radio frequency front-end module with impedance mismatch protection is provided, including at least one transmit channel. The transmit channel includes an input power measurement circuit, a power amplifier circuit, a matching circuit, a load measurement circuit, and a gain control circuit.

The input power measurement circuit is configured to measure power of an input radio frequency signal of the transmit channel. An input end of the input power measurement circuit is connected to a radio frequency signal input end. A first output end of the input power measurement circuit is connected to an input end of the power amplifier circuit. A second output end of the input power measurement circuit is connected to a first input end of the gain control circuit.

The power amplifier circuit is configured to: perform power amplification on the input radio frequency signal and then output the input radio frequency signal, and an output end of the power amplifier circuit is connected to an input end of the matching circuit.

The matching circuit is configured to implement impedance match, and an output end of the matching circuit is connected to an input end of the load measurement circuit.

The load measurement circuit is configured to: measure forward transmission power and reverse transmission power of an output radio frequency signal, and calculate a difference between the forward transmission power and the reverse transmission power as an output signal. A first output end of the load measurement circuit is connected to a radio frequency signal output end. A second output end of the load measurement circuit is connected to a second input end of the gain control circuit.

An output end of the gain control circuit is connected to a control end of the power amplifier circuit, and the gain control circuit is configured to: compare a received input power value with a first threshold, compare the difference between the output forward transmission power and the reverse transmission power with a second threshold, and output a control signal generated based on comparison results to the power amplifier circuit, so as to adjust an operating state of the power amplifier circuit to implement impedance mismatch protection.

Preferably, the load measurement circuit includes a first directional coupler, a second directional coupler, and a power difference calculation unit.

The first directional coupler and the second directional coupler are in reverse series connection in a radio frequency signal channel; an output end of the first directional coupler is connected to a first input end of the power difference calculation unit; an output end of the second directional coupler is connected to a second input end of the power difference calculation unit; and an output end of the power difference calculation unit is connected to the second input end of the gain control circuit.

Preferably, the first directional coupler is in forward connection to measure power of a radio frequency signal transmitted in a forward direction on the signal channel.

The second directional coupler is in reverse connection to measure power of a reflected signal that is generated in the signal channel due to impedance mismatch and is transmitted in a reverse direction.

Preferably, when load impedance mismatch occurs, the difference between the forward transmission power and the reverse transmission power that are measured by the first directional coupler and the second directional coupler reversely changes with a voltage standing wave ratio.

Preferably, the gain control circuit includes a first comparator, a second comparator, and a first AND gate.

A first input end of the first comparator is connected to an output end of the input power measurement circuit; a second input end of the first comparator is connected to a first threshold end; an output end of the first comparator is connected to a first input end of the first AND gate; a first input end of the second comparator is connected to an output end of the load measurement circuit; a second input end of the second comparator is connected to a second threshold end; an output end of the second comparator is connected to a second input end of the first AND gate; and an output end of the first AND gate is connected to a control end of an attenuator in the power amplifier circuit.

Preferably, when measured input power is greater than or equal to the first threshold and the difference between the forward transmission power and the reverse transmission power of the output signal is less than or equal to the second threshold, the first AND gate outputs a high-level control signal to control the attenuator in the power amplifier circuit to be activated, so that the input radio frequency signal of the transmit channel enters a power amplification unit after undergoing at least one attenuation; and at the time, the power amplifier circuit is in a protected operating state.

Preferably, when measured input power is less than the first threshold and/or the difference between the forward transmission power and the reverse transmission power of the output signal is greater than the second threshold, the first AND gate outputs a low-level control signal to control the attenuator in the power amplifier circuit to be deactivated, so that the input radio frequency signal of the transmit channel directly enters a power amplification unit; and the power amplifier circuit is in a normal operating state.

Preferably, an output end of the gain control circuit is connected to an adjustable bias circuit in the power amplifier circuit; the control signal outputted by the gain control circuit controls the adjustable bias circuit in the power amplifier circuit; and a gain of the power amplifier circuit is adjusted by adjusting a bias voltage or a bias current outputted by the adjustable bias circuit.

Preferably, the control signal outputted by the gain control circuit changes a magnitude of the output bias current or bias voltage by using a manner of controlling a bias resistor or a power supply in the adjustable bias circuit.

When the control signal outputted by the gain control circuit is at a high level, the bias current or bias voltage outputted by the adjustable bias circuit decreases, so that the gain of the power amplifier circuit decreases, and at the time, the power amplifier circuit is in a protected state.

When the control signal outputted by the gain control circuit is at a low level, the bias current or bias voltage outputted by the adjustable bias circuit remains in a normal value, and at the time, the power amplifier circuit is in a normal operating state.

According to a second aspect of the embodiments of the present invention, an electronic device is provided, including the above radio frequency front-end module with the impedance mismatch protection.

According to a third aspect of the embodiments of the present invention, a control method for implementing impedance mismatch protection by a radio frequency front-end module is provided, including the following steps:
(1) setting a first threshold and a second threshold;
(2) measuring input power of a radio frequency signal of a transmit channel;
(3) measuring forward transmission power and reverse transmission power of a radio frequency signal of an output end, and calculating a difference between the forward transmission power and the reverse transmission power;
(4) comparing the measured input power with a first threshold;
(5) comparing the difference between the measured forward transmission power and the measured reverse transmission power of the output end with a second threshold;
(6) when the measured input power is greater than or equal to the first threshold, and the difference between the forward transmission power and the reverse transmission power of the output end is less than or equal to the second threshold, executing step (7), otherwise, executing step (8);
(7) activating an attenuator in a power amplifier circuit, making an input radio frequency signal enter a power amplification unit through the attenuator, and then executing step (2); and
(8) deactivating the attenuator in the power amplifier circuit, making the input radio frequency signal directly enter the power amplification unit, and then executing step (2).

Preferably, step (7) includes the following substeps:
decreasing a bias current or a bias voltage in the power amplifier circuit to decrease a gain of the power amplifier circuit, and then executing step (2).

Preferably, step (8) includes the following substeps:
maintaining a bias current or a bias voltage in the power amplifier circuit during normal operation to maintain a gain of the power amplifier circuit during the normal operation, and then executing step (2).

Compared with the existing technology, the radio frequency front-end module with the impedance mismatch protection provided in the embodiments of the present invention uses the technical solution in which input power of a radio frequency signal and a forward output and reverse output power difference that represents a voltage standing wave ratio are measured in real time and a gain of the power amplifier circuit is dynamically adjusted, so that operating reliability of the power amplifier circuit is effectively protected in severe cases of relatively high input power and severe load impedance mismatch, and meanwhile, the power amplifier circuit can be smoothly restored to a normal operating state when severe operating conditions are relieved. Therefore, the radio frequency front-end module with the impedance mismatch protection provided in the embodiments of the present invention has beneficial effects of skillful and proper structural design, relatively low design costs, high operating reliability, excellent circuit performance, and the like.

### BRIEF DESCRIPTION OF THE DRAWINGS

FIG. 1 is a structural block diagram of a radio frequency front-end module with impedance mismatch protection according to an embodiment of the present invention;
FIG. 2 is a schematic circuit diagram of a radio frequency front-end module with impedance mismatch protection in an embodiment of the present invention;
FIG. 3 is a curve graph of differences between forward transmission power and reverse transmission power in different VSWRs in an embodiment of the present invention;
FIG. 4 is a schematic circuit diagram of a radio frequency front-end module with impedance mismatch protection in another embodiment of the present invention;
FIG. 5 is a structural circuit diagram of an adjustable bias circuit in another embodiment of the present invention;
FIG. 6 is an operating flowchart of a control method for implementing impedance mismatch protection by a radio frequency front-end module in an embodiment of the present invention; and
FIG. 7 is a schematic diagram of an electronic device using a radio frequency front-end module impedance mismatch protection according to an embodiment of the present invention.

### DETAILED DESCRIPTION

Technical contents of the present invention will be described in detail below with reference to the accompanying drawings and specific embodiments.

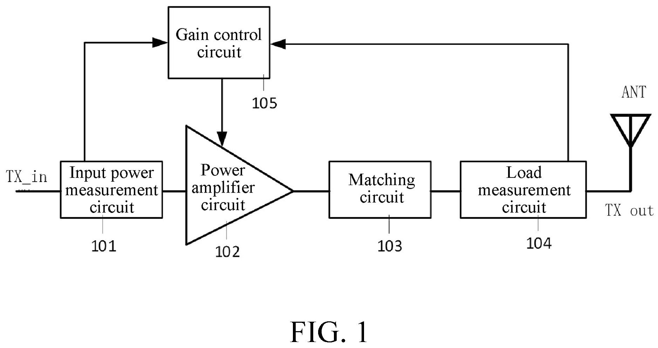

As shown in FIG. 1, a radio frequency front-end module with impedance mismatch protection provided in this embodiment of the present invention includes at least one transmit channel. The transmit channel includes an input power measurement circuit 101, a power amplifier circuit 102, a matching circuit 103, a load measurement circuit 104, and a gain control circuit 105. A radio frequency signal input end TX_in is connected to an input end of the input power measurement circuit 101. A first output end of the input power measurement circuit 101 is connected to an input end of the power amplifier circuit 102. A second output end of the input power measurement circuit 101 is connected to a first input end of the gain control circuit 105. An output end of the power amplifier circuit 102 is connected to an input end of the matching circuit 103. An output end of the matching circuit 103 is connected to an input end of the load measurement circuit 104. A first output end of the load measurement circuit 104 is connected to a radio frequency signal output end TX_out. A second output end of the load measurement circuit 104 is connected to a second input end of the gain control circuit 105. An output end of the gain control circuit 105 is connected to a control end of the power amplifier circuit 102. The radio frequency signal output end TX_out is connected to an antenna ANT.

The input power measurement circuit 101 is configured to: measure power of an input radio frequency signal of the transmit channel, and output a measurement result to the gain control circuit 105. The input power measurement circuit may be implemented by using a directional coupler.

The power amplifier circuit 102 is configured to perform power amplification on the input radio frequency signal and then output the input radio frequency signal. The power amplifier circuit generally includes a power amplification circuit and an adjustable bias circuit, and may further include an attenuator and the like according to specific needs.

The matching circuit 103 is configured to implement impedance match, and generally includes passive components such as a capacitor and an inductor.

The load measurement circuit 104 is configured to: measure forward transmission power and reverse transmission power of an output radio frequency signal, and output a difference between the forward transmission power and the reverse transmission power to the gain control circuit 105.

The gain control circuit 105 is configured to respectively compare a received input power value and the difference between the output forward transmission power and the reverse transmission power with a set first threshold and a set second threshold, output a control signal generated based on comparison results to the power amplifier circuit 102, and adjust an operating state of the power amplifier circuit.

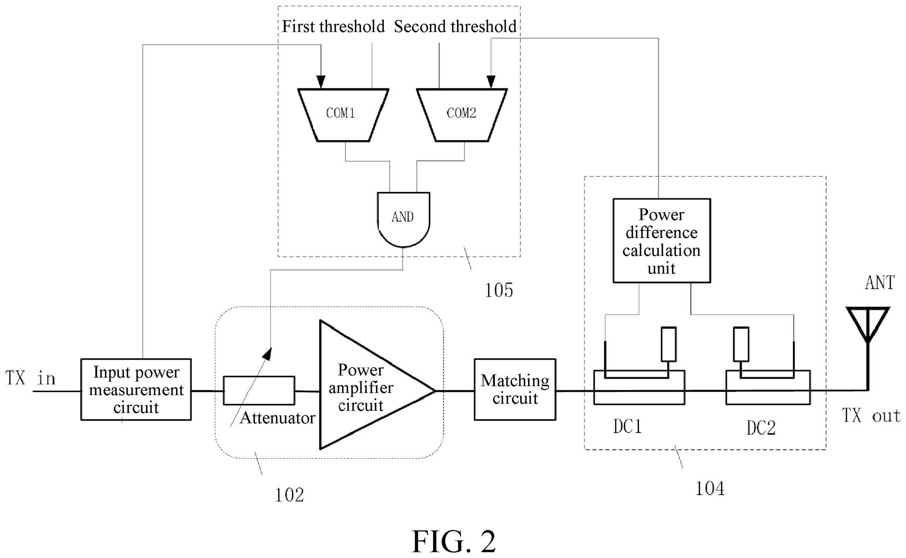

As shown in FIG. 2, in an embodiment of the present invention, the load measurement circuit 104 includes a first directional coupler DC1, a second directional coupler DC2, and a power difference calculation unit. The first directional coupler DC1 and the second directional coupler DC2 are in reverse series connection in a radio frequency signal channel. An output end of the first directional coupler DC1 is connected to a first input end of the power difference calculation unit. An output end of the second directional coupler DC2 is connected to a second input end of the power difference calculation unit. An output end of the power difference calculation unit is connected to the second input end of the gain control circuit 105.

The first directional coupler DC1 is in forward connection to measure power of a radio frequency signal transmitted in a forward direction on the radio frequency signal channel; and the second directional coupler DC2 is in reverse connection to measure power of a reflected signal that is generated in the signal channel due to impedance mismatch and is transmitted in a reverse direction. When a load resistance is 50 Ω (or may be another impedance value), the difference between the forward transmission power and the reverse transmission power that are measured by the first directional coupler DC1 and the second directional coupler DC2 is the same as an isolation degree of a directional coupler. When load impedance mismatch occurs, the difference between the forward transmission power and the reverse transmission power that are measured by the first directional coupler DC1 and the second directional coupler DC2 decreases.

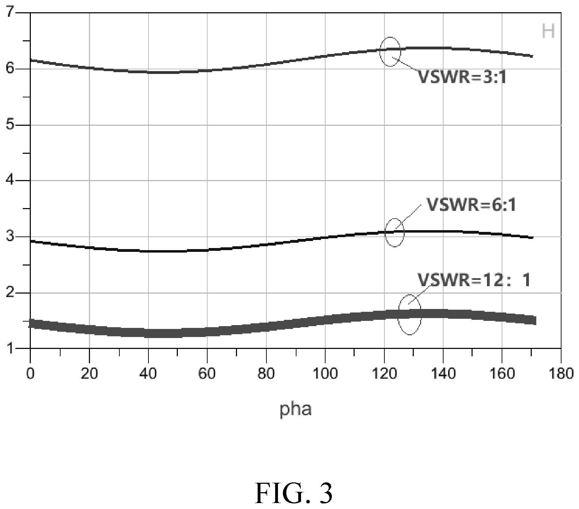

As shown in FIG. 3, a voltage standing wave ratio (VSWR) is also different based on different degrees of load impedance mismatch, and the difference between forward transmission power and the reverse transmission power that are measured by the first directional coupler DC1 and the second directional coupler DC2 is also different. In FIG. 3, a horizontal axis represents a phase, and a vertical axis represents the difference between the forward transmission power and the reverse transmission power. When the voltage standing wave ratio is 3:1, in a full-phase, the difference between the forward transmission power and the reverse transmission power is 6.2 dB. When the voltage standing wave ratio is 6:1, in the full-phase, the difference between the forward transmission power and the reverse transmission power is 3 dB. When the voltage standing wave ratio is 12:1, in the full-phase, the difference between the forward transmission power and the reverse transmission power is 1.5 dB.

That is, the difference between the forward transmission power and the reverse transmission power that are measured by the first directional coupler DC1 and the second directional coupler DC2 decreases (that is, reversely changes) as the voltage standing wave ratio increases, and a larger voltage standing wave ratio indicates a larger degree of load impedance mismatch.

A circuit structure of the power difference calculation unit may be in a form composed of electronic components, or may be in a form composed of electronic components and processed by an algorithm.

As shown in FIG. 2, in an embodiment of the present invention, the gain control circuit 105 includes a first comparator COM1, a second comparator COM2, and a first AND gate AND. A first input end of the first comparator COM1 is connected to an output end of the input power measurement circuit. A second input end of the first comparator COM1 is connected to a first threshold end set by a system. An output end of the first comparator COM1 is connected to a first input end of the first AND gate AND. A first input end of the second comparator COM2 is connected to an output end of the load measurement circuit. A second input end of the second comparator COM2 is connected to a second threshold end set by the system. An output end of the second comparator COM2 is connected to a second input end of the first AND gate AND. An output end of the first AND gate AND is connected to a control end of an attenuator in the power amplifier circuit.

The first comparator COM1 is configured to compare radio frequency signal input power measured by the input power measurement circuit with a first threshold set by the system. The first threshold is a set input power value. When a measured input power value is greater than or equal to the first threshold, the first comparator COM1 outputs a high level, and otherwise, outputs a low level. The second comparator COM2 is configured to compare the difference between the forward transmission power and the reverse transmission power of the radio frequency signal measured by the load measurement circuit with a second threshold set by the system. The second threshold is a difference between forward transmission power and reverse transmission power in a particular voltage standing wave ratio when set-load-impedance mismatch occurs. When the difference between the forward transmission power and the reverse transmission power of the radio frequency signal measured by the load measurement circuit is less than or equal to the second threshold, the second comparator COM2 outputs a high level, and otherwise, outputs a low level. After output signals of the first comparator COM1 and the second comparator COM2 pass through the first AND gate AND, a control signal is outputted, to control the attenuator in the power amplifier circuit.

When measured input power value is greater than or equal to the first threshold, and the difference between the forward transmission power and the reverse transmission power of the output signal is less than or equal to the second threshold, the first AND gate AND outputs a high-level control signal, to control the attenuator in the power amplifier circuit to be activated, so that the input radio frequency signal of the transmit channel enters a power amplification unit after undergoing at least one attenuation.

When measured input power is less than the first threshold and/or the difference between the forward transmission power and the reverse transmission power of the output signal is greater than the second threshold, the first AND gate AND outputs a low-level control signal to control the attenuator in the power amplifier circuit to be deactivated, so that the input radio frequency signal of the transmit channel directly enters a power amplification unit.

That is, when the input power value is less than the first threshold, no matter how large the voltage standing wave ratio that represents the degree of load impedance mismatch is, the attenuator in the power amplifier circuit is not activated. In this case, the power amplifier circuit is still in the normal operating state. In another aspect, when the difference between the forward transmission power and the reverse transmission power of the output signal is greater than the second threshold, regardless of the magnitude of the input power, the attenuator in the power amplifier circuit is not activated. In this case, the power amplifier circuit is still in the normal operating state. Only when the measured input power is greater than or equal to the first threshold and the difference between the forward transmission power and the reverse transmission power of the output signal is less than or equal to the second threshold, the attenuator in the power amplifier circuit is activated. In this case, the power amplifier circuit is in the protected operating state, thereby ensuring that the power amplifier circuit cannot be burned out.

When the power amplifier circuit is in the protected operating state, if the input power decreases to be less than the first threshold, the first comparator COM1 outputs a low level, the first AND gate AND outputs a low-level control signal, the attenuator in the power amplifier circuit is deactivated, and the power amplifier circuit is restored to the normal operating state to keep a normal gain. If the difference between the forward transmission power and the reverse transmission power of the output signal increases to be greater than the second threshold, the second comparator COM2 outputs a low level, the first AND gate AND outputs a low-level control signal, the attenuator in the power amplifier circuit is deactivated, and the power amplifier circuit is restored to the normal operating state to keep a normal gain.

It can be seen from the analysis of the above operating principle that, the technical solutions provided in this embodiment of the present invention can effectively protect the power amplifier circuit in severe cases of relatively high input power and severe load impedance mismatch, and can smoothly restore the power amplifier circuit to the normal operating state when severe working conditions are mitigated.

The attenuator in the power amplifier circuit is connected in series to an input end of a power amplification unit in the signal channel, and may be implemented by using an array circuit including a switch, a resistor, and a capacitor.

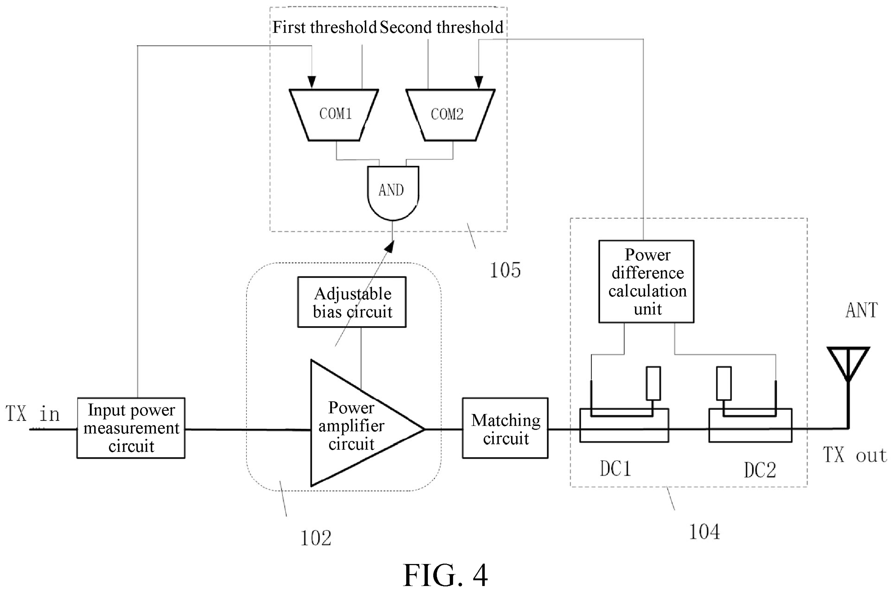

As shown in FIG. 4, in another embodiment of the present invention, the radio frequency front-end module with the impedance mismatch protection includes at least one transmit channel. The transmit channel includes an input power measurement circuit, a power amplifier circuit 102, a matching circuit, a load measurement circuit 104, and a gain control circuit 105. Structures of the load measurement circuit 104, the gain control circuit 105, the input power measurement circuit, and the matching circuit are the same as those of the above embodiment. A difference is that the output end of the gain control circuit 105 is connected to an adjustable bias circuit in the power amplifier circuit 102.

In this embodiment, a control signal outputted by the gain control circuit 105 controls the adjustable bias circuit in the power amplifier circuit 102, and adjusts a gain of the power amplifier circuit by adjusting a magnitude of a bias voltage or bias current outputted by the adjustable bias circuit, thereby effectively protecting the power amplifier circuit in severe cases of relatively high input power and severe load impedance mismatch, and smoothly restoring the power amplifier circuit to the normal operating state when severe working conditions are mitigated. Other specific operating processes of the technical solutions provided in this embodiment are the same as those of the foregoing embodiments and will not be elaborated here.

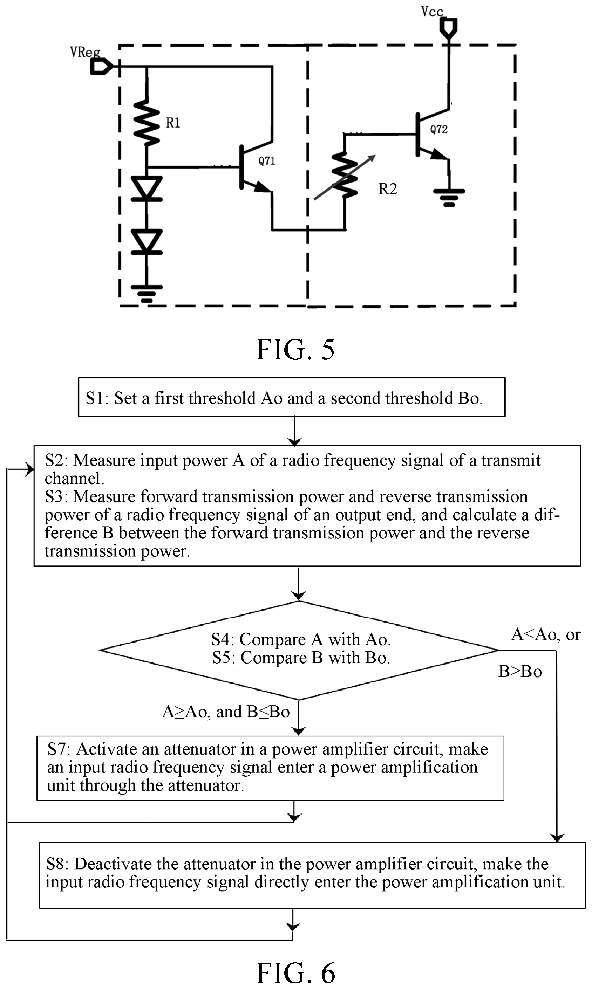

A circuit structure of the adjustable bias circuit in the power amplifier circuit 102 is shown in FIG. 5. The control signal outputted by the gain control circuit 105 can change the magnitude of the output bias current or bias voltage in a manner of adjusting a bias resistor R2 or a power supply Vcc, to adjust the gain of the power amplifier circuit.

When the control signal outputted by the gain control circuit 105 is at a high level, the bias current or bias voltage outputted by the adjustable bias circuit decreases, so that the gain of the power amplifier circuit decreases, and at the time, the power amplifier circuit is in a protected state. When the control signal outputted by the gain control circuit 105 is at a low level, the bias current or bias voltage outputted by the adjustable bias circuit remains in a normal value, and at the time, the power amplifier circuit is in a normal operating state.

An operating flow of a control for impedance mismatch protection of the radio frequency front-end module with the impedance mismatch protection provided in this embodiment of the present invention is shown in FIG. 6, specifically including the following steps:
S1: Set a preset input power value of an input end to be a first threshold, and set a preset difference between forward transmission power and reverse transmission power of an output end to be a second threshold.
S2: Measure input power of a radio frequency signal of a transmit channel.
S3: Measure forward transmission power and reverse transmission power of a radio frequency signal of the output end, and calculate a difference between the forward transmission power and the reverse transmission power.
S4: Compare the measured input power with the first threshold.
S5: Compare the difference between the measured forward transmission power and the measured reverse transmission power of the output end with the second threshold.
S6: When the measured input power is greater than or equal to the first threshold, and the difference between the forward transmission power and the reverse transmission power of the output end is less than or equal to the second threshold, execute step S7, otherwise, execute step S8.
S7: Activate an attenuator in a power amplifier circuit, make an input radio frequency signal enter a power amplification unit through the attenuator, and then execute step S2.
S8: Deactivate the attenuator in the power amplifier circuit, make the input radio frequency signal directly enter the power amplification unit, and then execute step S2.

In the above operating flow, step S2 and step S3 are executed simultaneously, and step S4 and step S5 are also executed simultaneously. In addition, step S7 and step S8 may further use the following technical solution:
S71: Decrease a bias current or a bias voltage in the power amplifier circuit to decrease a gain of the power amplifier circuit, and then execute step S2.

S81: Maintain a bias current or a bias voltage in the power amplifier circuit during normal operation to maintain a gain of the power amplifier circuit during the normal operation, and then execute step S2.

Based on the foregoing radio frequency front-end module with the impedance mismatch protection, an embodiment of the present invention further provides an electronic device, including the above radio frequency front-end module with the impedance mismatch protection. The radio frequency front-end module may be used as an important constituent part of a communication component. The electronic device herein refers to a computer device that may be used in a mobile environment and supports various communication standards such as global system for mobile communications (GSM), enhanced data rates for GSM evolution (EDGE), code division multiple access (CDMA), time division-synchronous code division multiple access (TD_SCDMA), wideband code division multiple access (WCDMA), time division duplexing-long term evolution (TDD_LTE), frequency division duplexing-long term evolution (FDD_LTE), and new radio (NR), and includes a mobile phone, a notebook computer, a tablet computer, an in-vehicle computer, and the like. In addition, the technical solutions provided in the present invention are also applicable to occasions of other radio frequency integrated circuit applications, such as a communications base station and an intelligent connected vehicle.

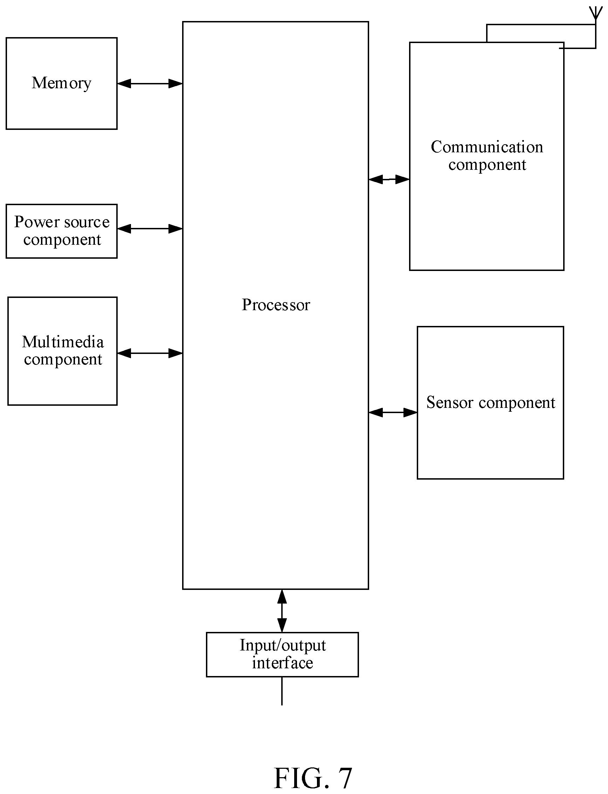

As shown in FIG. 7, the electronic device at least includes a processor, a memory, and a communication component, and may further include, based on an actual need, a sensor component, a power source component, a multimedia component, an input/output interface, and the like. The memory, the communication component, the sensor component, the power source component, the multimedia component, and the input/output interface are all connected to the processor. The memory may be a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, or the like. The processor may be a central processing unit (CPU), a graphics processing unit (GPU), a field programmable gate array (FPGA), an application-specific integrated circuit (ASIC), a digital signal processing (DSP) chip, or the like. Other components such as the communication component, the sensor component, the power source component, and the multimedia component may be implemented by using general-purpose components, and will not be specifically described here.

In conclusion, compared with the existing technology, the radio frequency front-end module with the impedance mismatch protection provided in the embodiments of the present invention uses the technical solution, in which input power of a radio frequency signal and a forward output and reverse output power difference that represents a voltage standing wave ratio are measured in real time and a gain of the power amplifier circuit is dynamically adjusted, so that operating reliability of the power amplifier circuit is effectively protected in severe cases of relatively high input power and severe load impedance mismatch, and meanwhile, the power amplifier circuit can be smoothly restored to a normal operating state when severe operating conditions are relieved. Therefore, the radio frequency front-end module with the impedance mismatch protection provided in the present invention has beneficial effects of skillful and proper structural design, relatively low design costs, high operating reliability, excellent circuit performance, and the like.

It should be noted that the plurality of embodiments are merely examples, and the technical solutions of the embodiments may be combined, all of which fall within the protection scope of the present invention.

In addition, the terms "first" and "second" are used for descriptive purposes only and are not to be construed as indicating or implying relative importance or to implicitly indicate the number of technical features indicated. Thus, features defined as "first" and "second" explicitly or implicitly include one or more of the features. In the description of the present invention, "plurality" means two or more, unless otherwise expressly and specifically defined.

The above describes in detail the radio frequency front-end module with the impedance mismatch protection, the electronic device, and the method provided in the present invention. For those of ordinary skill in the art, any obvious changes made to the present invention without deviating from its substantive content will constitute infringement of the patent rights of the present invention, and they will bear corresponding legal responsibilities.

## Claims

1. A radio frequency front-end module with impedance mismatch protection, comprising at least one transmit channel, wherein the transmit channel comprises an input power measurement circuit, a power amplifier circuit, a matching circuit, a load measurement circuit, and a gain control circuit;
the input power measurement circuit is configured to measure power of an input radio frequency signal of the transmit channel; an input end of the input power measurement circuit is connected to a radio frequency signal input end; a first output end of the input power measurement circuit is connected to an input end of the power amplifier circuit; a second output end of the input power measurement circuit is connected to a first input end of the gain control circuit;
the power amplifier circuit is configured to: perform power amplification on the input radio frequency signal and then output the input radio frequency signal, and an output end of the power amplifier circuit is connected to an input end of the matching circuit;
the matching circuit is configured to implement impedance match, and an output end of the matching circuit is connected to an input end of the load measurement circuit;
the load measurement circuit is configured to: measure forward transmission power and reverse transmission power of an output radio frequency signal, and calculate a difference between the forward transmission power and the reverse transmission power as an output signal; a first output end of the load measurement circuit is connected to a radio frequency signal output end; a second output end of the load measurement circuit is connected to a second input end of the gain control circuit; and
an output end of the gain control circuit is connected to a control end of the power amplifier circuit, and the gain control circuit is configured to: compare a received input power value with a first threshold, compare the difference between the forward transmission power and the reverse transmission power with a second threshold, and output a control signal generated based on comparison results to the power amplifier circuit, so as to adjust an operating state of the power amplifier circuit to implement impedance mismatch protection.

2. The radio frequency front-end module with the impedance mismatch protection according to claim 1, wherein
the load measurement circuit comprises a first directional coupler, a second directional coupler, and a power difference calculation unit;
the first directional coupler and the second directional coupler are in reverse series connection in a radio frequency signal channel; an output end of the first directional coupler is connected to a first input end of the power difference calculation unit; an output end of the second directional coupler is connected to a second input end of the power difference calculation unit; and an output end of the power difference calculation unit is connected to the second input end of the gain control circuit.

3. The radio frequency front-end module with the impedance mismatch protection according to claim 2, wherein
the first directional coupler is in forward connection to measure power of a radio frequency signal transmitted in a forward direction on the radio frequency signal channel; and
the second directional coupler is in reverse connection to measure power of a reflected signal that is generated in the signal channel due to impedance mismatch and is transmitted in a reverse direction.

4. The radio frequency front-end module with the impedance mismatch protection according to claim 2, wherein
when load impedance mismatch occurs, the difference between the forward transmission power and the reverse transmission power that are measured by the first directional coupler and the second directional coupler reversely changes with a voltage standing wave ratio.

5. The radio frequency front-end module with the impedance mismatch protection according to claim 1, wherein
the gain control circuit comprises a first comparator, a second comparator, and a first AND gate;
a first input end of the first comparator is connected to an output end of the input power measurement circuit; a second input end of the first comparator is connected to a first threshold end; an output end of the first comparator is connected to a first input end of the first AND gate; a first input end of the second comparator is connected to an output end of the load measurement circuit; a second input end of the second comparator is connected to a second threshold end; an output end of the second comparator is connected to a second input end of the first AND gate; and an output end of the first AND gate is connected to a control end of an attenuator in the power amplifier circuit.

6. The radio frequency front-end module with the impedance mismatch protection according to claim 5, wherein
when measured input power value is greater than or equal to the first threshold and the difference between the forward transmission power and the reverse transmission power of the output signal is less than or equal to the second threshold, the first AND gate outputs a high-level control signal to control the attenuator in the power amplifier circuit to be activated, so that the input radio frequency signal of the transmit channel enters a power amplification unit after undergoing at least one attenuation; and at the time, the power amplifier circuit is in a protected operating state.

7. The radio frequency front-end module with the impedance mismatch protection according to claim 5, wherein
when measured input power value is less than the first threshold and/or the difference between the forward transmission power and the reverse transmission power of the output signal is greater than the second threshold, the first AND gate outputs a low-level control signal to control the attenuator in the power amplifier circuit to be deactivated, so that the input radio frequency signal of the transmit channel directly enters a power amplification unit; and at the time, the power amplifier circuit is in a normal operating state.

8. The radio frequency front-end module with the impedance mismatch protection according to claim 5, wherein
an output end of the gain control circuit is connected to an adjustable bias circuit in the power amplifier circuit; the control signal outputted by the gain control circuit controls the adjustable bias circuit in the power amplifier circuit; and a gain of the power amplifier circuit is adjusted by adjusting a bias voltage or a bias current outputted by the adjustable bias circuit.

9. The radio frequency front-end module with the impedance mismatch protection according to claim 8, wherein
the control signal outputted by the gain control circuit changes a magnitude of the output bias current or bias voltage by using a manner of controlling a bias resistor or a power supply in the adjustable bias circuit;
when the control signal outputted by the gain control circuit is at a high level, the bias current or bias voltage outputted by the adjustable bias circuit decreases, so that the gain of the power amplifier circuit decreases, and at the time, the power amplifier circuit is in a protected state; and
when the control signal outputted by the gain control circuit is at a low level, the bias current or bias voltage outputted by the adjustable bias circuit remains in a normal value, and at the time, the power amplifier circuit is in a normal operating state.

10. An electronic device, comprising the radio frequency front-end module with impedance mismatch protection according to any one of claims 1 to 9.

11. A control method for implementing impedance mismatch protection by a radio frequency front-end module, comprising the following steps:
(1) setting a first threshold and a second threshold;
(2) measuring input power of a radio frequency signal of a transmit channel;
(3) measuring forward transmission power and reverse transmission power of a radio frequency signal of an output end, and calculating a difference between the forward transmission power and the reverse transmission power;
(4) comparing the measured input power with a first threshold;
(5) comparing the difference between the measured forward transmission power and the measured reverse transmission power of the output end with a second threshold;
(6) when the measured input power is greater than or equal to the first threshold, and the difference between the forward transmission power and the reverse transmission power of the output end is less than or equal to the second threshold, executing step (7), otherwise, executing step (8);
(7) activating an attenuator in a power amplifier circuit, making an input radio frequency signal enter a power amplification unit through the attenuator, and then executing step (2); and
(8) deactivating the attenuator in the power amplifier circuit, making the input radio frequency signal directly enter the power amplification unit, and then executing step (2).

12. The control method for implementing the impedance mismatch protection by the radio frequency front-end module according to claim 11, wherein step (7) comprises the following substeps:
decreasing a bias current or a bias voltage in the power amplifier circuit to decrease a gain of the power amplifier circuit, and then executing step (2).

13. The control method for implementing the impedance mismatch protection by the radio frequency front-end module according to claim 11, wherein step (8) comprises the following substeps:
maintaining a bias current or a bias voltage in the power amplifier circuit during normal operation to maintain a gain of the power amplifier circuit during the normal operation, and then executing step (2).
